# EUROPEAN PATENT APPLICATION

(11) **EP 3 309 736 A1**
(43) Date of publication of application: **18.04.2018**
(21) Application number: 17169908.5
(22) Date of filing: 08.05.2017
(51) Int. Cl.: G06Q 50/06, G01R 31/02

(54) **METHOD, DEVICE AND SYSTEM FOR MARKING MEASUREMENT POINTS IN THE ELECTRICAL NETWORK OF A BUILDING OR PROPERTY, METHOD AND DEVICE FOR COLLECTING MEASUREMENT INFORMATION FROM THE MEASUREMENT POINTS IN THE ELECTRICAL NETWORK OF A BUILDING OR PROPERTY, METHOD FOR THE MAINTENANCE OF THE ELECTRICAL NETWORK OF A BUILDING OR PROPERTY**

(30) Priority: 11.10.2016 FI 20165772
(71) Applicant: Martten Finland Oy, 15610 Lahti (FI)
(72) Inventor: Tommola, Jukka, 15320 Lahti (FI); Suomi, Jussi, 15140 Lahti (FI); Jauhiainen, Risto, 15700 Lahti (FI)
(74) Representative: Genip Oy

(57) **Abstract**

In the method for the marking of the measurement points (31) - most advantageously at least of the socket outlets, earthing points and lighting points - in the electrical network of a building or property:
- an identifier (10), which contains information on each measurement point (31), is established automatically on the basis of the electrical network information included in a switchboard;
- the identifier (10) of each measurement point (31) is printed onto a marking device (12); and
- the marking device (12) is fastened to the measurement point (31) or to its immediate vicinity.

Also includes a device claim and system claim as well as parallel method claims.

## Description

### Field of invention

The invention is related to electrical engineering, more specifically to the marking of measurement points in the electrical network of a building or property and on the other hand also to the collection of measurement information from the measurement points in the electrical network of a building or property as well as to the maintenance of said electrical networks.

### Technical background

An electrical connection to the electrical network of a distribution company is usually made in Finland individually for each property. A single-family house is usually built on a property (plot). Separate buildings, terraced houses and blocks of flats as well as office buildings, schools or for instance factories are also buildings, and each of them may have their own property-specific or building-specific electrical connection. On the other hand, for example an individual apartment in a terraced house or block of flats usually does not have its own electrical connection, but an apartment is still a metering point of its own in terms of billing.

In what follows, the electrical network of a building or property means the parts of the distribution network after the electrical connection, in other words the switchboard (in other words the main switchboard and distribution switchboards) and wiring.

In what follows, the measurement point in the electrical network of a building or property means an individual socket outlet point, lighting point and/or earthing point in the electrical network of a building or property.

In practice, every time before a property or a building is taken into use, a commissioning inspection is performed on the electrical network by measuring for example the functioning of protective earthing at each measurement point. Moreover, the electrical network and its equipment must be performed a periodic measurement at prescribed intervals. The industry has its own standards for performing the measurements (for example SFS 6000-6-61).

As an example, a) electrical equipment in an explosive facility, where the manufacture and handling of a hazardous chemical or the manufacture of an explosive requires a permit and b) electrical equipment in medical facilities in such a hospital or health centre or in such a private clinic, where surgical operations requiring general anaesthesia or comprehensive local anaesthesia are performed, are both classified as class 3 electrical equipment in Finland. Such class 3 electrical equipment must be performed a periodic measurement, in other words for example the functioning of protective earthing must be measured at each measurement point at prescribed intervals. A periodic measurement must also be repeated at prescribed intervals on class 2 electrical equipment.

### Objective of invention

The first objective of the invention is to expedite the making of electrical installations in a building or property. This objective can be accomplished by means of the method according to claim 1 and by means of the device or system according to claim 13.

The second objective of the invention is to increase the reliability of the measurement points in the electrical network of a building or property. This objective can be accomplished by means of the method according to claim 6.

The third objective of the invention is to simplify the performing of the periodic measurement of the electrical network of a building or property. This objective can be accomplished by means of the method according to claim 7.

The fourth objective of the invention is to facilitate the maintenance of the electrical network of a building or property. This objective can be accomplished by means of the method according to claim 11 and by means of the device according to claim 14.

### Advantages of invention

In the method for the marking of the measurement points - most advantageously at least of the socket outlets, earthing points and lighting points - in the electrical network of a building or property:
i) an identifier, which contains information on each measurement point, is established automatically on the basis of the electrical network information included in a switchboard, ii) the identifier of each measurement point is printed onto a marking device, and iii) the marking device (12) is fastened to the measurement point or to its immediate vicinity.

By means of the method, the printing of the marking devices of the measurement points in the electrical network of a building or property can be automated: the marking devices can be printed in this way directly on the basis of the electrical network information - most advantageously on the basis of the switchboard diagram information and/or cable installation list information. When the printing of the marking devices is expedited, the entire process of making the electrical installations in a building or property is also expedited.

The identifier is most preferably a remote-readable code or comprises one. The remote-readable code used is most advantageously an optically readable code, such as a bar code or a 2D bar code, or an RFID chip identifier.

The marking device is most advantageously a label or comprises a label.

According to the most advantageous embodiment of the method, the identifier individualises each measurement point in the electrical network of a building or property unambiguously.

All socket outlets in each socket outlet group are currently marked in accordance with the electrical network information on the property or building so that all socket outlets in a socket outlet group are assigned an identifier, which corresponds to the switchboard diagram and/or cable installation list. As an example, the identifier of the distribution switchboard and the number of the socket outlet group connected to it can be used, for example the code of the fourth socket outlet group in distribution switchboard "JK-12" is usually "JK-12/4".

The inventors have noticed that because all socket outlets in the same socket outlet group are currently marked with the same identifier, it is impossible to know from which individual socket outlet the measurement results of for example a commissioning inspection or periodic measurement have come from.

In this way, the measurement results of for example a commissioning inspection or periodic measurement are currently not very reliable, and their measurement results cannot be compared to earlier results. This also applies to the processing of the results of measurements carried out at the earthing points and lighting points.

When the identifier of the measurement point individualises the measurement point in the electrical network of a building or property unambiguously according to the most advantageous embodiment of the method according to the invention, the situation becomes completely different: this especially enables the comparison of the measurement results of each measurement point to earlier measurement results.

In the method for the collection of measurement information from the measurement points in the electrical network of a building or property on the basis of the electrical network information included in the switchboard - most advantageously on the basis of the switchboard diagram and/or cable installation list - i) a data structure that comprises identifiers, which contain information on each measurement point and which individualise each measurement point in the electrical network of a building or property unambiguously, is established automatically, and ii) commissioning inspections or periodic measurements are carried out at the measurement points marked using the identifiers, which individualise each measurement point in the electrical network of the building or property unambiguously - most advantageously according to the method described above - and the measurement results are combined with the identifier, which individualises the measurement point in the data structure unambiguously. By means of the method, the carrying out of the commissioning inspection and periodic measurement of a building or property can be simplified, and on the other hand the reliable measurement of the measurement points in the electrical network of a building or property can be enabled.

Each individualising identifier can especially be read by means of a detector that is included in a measuring device or by means of a detector that is connected to a measuring device. In this way, the manual collection of the identifiers can be avoided, and it can also be required, if necessary, that the individualising identifiers have certainly been read by using a detector that is included in a measuring device or by means of a detector that is connected to a measuring device. This enables for the first time that the authenticity of the measurement results of the measurement points in the electrical network of a building or property is ensured, in other words that the measurement point has at least certainly been accessed for the measurements.

In practice, the measurer cannot modify the measurement results saved in the memory of the measuring device, which measurement results can be time-stamped if necessary. It is not possible to modify the measurement results manually or add them manually using the measuring device. Only actually measured values can be saved in the memory of the measuring device. Complete measurement values cannot be taken into the database (or remote database) of the meter, only the measurement points to be measured. They can be processed most advantageously only after the information obtained from the measuring device has been taken into a computer or server. In other words, if the client wishes to make sure that the measurements have really been carried out, it is the client who has to export the database of the measuring device to his computer or server.

The invention is based on the idea that when we have assigned individualising identifier codes to the measurement points, we obtain precise measurement results from said measurement points. By comparing these to earlier measurements or to measurement results obtained in a periodic inspection, potential fabricated measurement results differ so much from the correct values that they are detected.

The identifier most advantageously comprises a remote-readable code - most advantageously a bar code or a 2D bar code or an RFID chip identifier - and the detector comprises an optical scanner, most advantageously a hand-held scanner or an RFID reading device, for the reading of the remote-readable code. The scanner/reading device and/or measuring device is in this case most advantageously configured to interpret the remote-readable code.

The measuring device used in the method advantageously comprises:
i) a data structure that comprises identifiers, which individualise the measurement points in the electrical network of a building or property unambiguously, and that is saved in a measuring device, into which data structure each measurement result is saved so that the measurement result is combined with the identifier, which individualises the measurement point unambiguously;
   and/or
ii) data communications devices for sending each measurement result via a data communications connection to a processing device together with the identifier, which individualises the measurement point in the electrical network of a building or property unambiguously in each case.

In this case, it can be monitored that all measurement points in the electrical network of a building or property are covered.

In the method for the maintenance of the electrical network of a building or property:
- the method as described above is used for collecting measurement results from the measurement points in the electrical network of a building or property together with an identifier, which individualises each measurement point unambiguously in each case; and
- the measurement results of each measurement point are analysed as a time series, in other words by comparing to earlier measurement results, in order to detect and/or report faults caused by the design, building or wear of the electrical network of the property.

In this way, the maintenance of the electrical network of a building or property can be facilitated. The method is most advantageously used for predicting the wear of the electrical network of a building or property and for detecting or predicting the leakage of potential protective earthing.

The device or system for the marking of the measurement points - most advantageously at least of the socket outlets, earthing points and lighting points - in the electrical network of a building or property comprises:
- devices for the automatic establishment of an identifier, which contains information on each measurement point, on the basis of the electrical network information included in the switchboard - most advantageously on the basis of the switchboard diagram and/or cable installation list - and
- devices for sending each identifier to a marking device for printing, for example by means of a label printer.

The device for the collection of measurement information from the measurement points in the electrical network of a building or property comprises:
devices for the reading of the identifiers, which individualise the measurement points in the electrical network of a building or property unambiguously;
and
a) a data structure saved in the device, into which data structure each measurement result made with the device is saved so that the measurement result is combined with the identifier, which individualises the measurement point unambiguously;
   and/or
b) data communications devices for sending each measurement result from the device via a data communications connection to a processing device together with the identifier, which individualises the measurement point in the electrical network of a building or property unambiguously in each case.

### List of drawings

In what follows, the invention is presented in more detail by means of the exemplary embodiment shown in the enclosed drawings. Of the drawings:
- FIG 1: shows a switchboard diagram;
- FIG 2: shows the automatic printing of the marking labels, which contain the unambiguous identifier of the measurement point, by means of a label printer;
- FIG 3: shows the marking label, which contains the unambiguous identifier of the measurement point, fastened to the measurement point;
- FIG 4: shows the reading of the unambiguous identifier of the measurement point in the electrical network of a building or property in connection with a collection event.

The same reference numbers refer to the same technical characteristics in all FIGs.

### Detailed description

In the method for the marking of the measurement points - most advantageously at least of the socket outlets 31, earthing points and lighting points - in the electrical network of a building or property, an identifier 10, which contains information on each measurement point, is established automatically on the basis of the electrical network information included in a switchboard. The identifier 10 of each measurement point is printed onto a marking device 12 of its own, and the marking device 12 is fastened to the measurement point or to its immediate vicinity.

The electrical network information used is most advantageously a switchboard diagram 9 and/or a cable installation list.

The identifier 10 best comprises a remote-readable code or is a remote-readable code. The code can be an optically readable code, most advantageously a bar code or a 2D bar code or an RFID chip identifier.

The identifier 10 best individualises each measurement point in the electrical network of a building or property unambiguously.

On the basis of the information obtained from the switchboard diagram 9 or from electrical drawings, for example a label printer 13 can be used for printing individual marking devices 12 (such as labels) of socket outlets, lighting fixtures and earthing points, and a database or other suitable data structure can be established of these. The database or data structure can be transferred into a measuring device 40 or for example into a data system, into which measurement results are transferred from the measuring device 40.

In the method for the collection of measurement information from the measurement points in the electrical network of a building or property on the basis of the electrical network information included in the switchboard, a data structure that comprises identifiers 10, which contain information on each measurement point and which individualise each measurement point in the electrical network of a building or property unambiguously, is established automatically, and commissioning inspection measurements or periodic measurements are carried out at the measurement points marked using the identifiers, which individualise each measurement point in the electrical network of the building or property unambiguously, and the measurement results are combined with the identifier 10, which individualises the measurement point in the data structure unambiguously.

An applicable measuring device is used in the commissioning inspection measurements or periodic measurements. We have used for example GMC-I Messtechnik GmbH's Gossen® Metrawatt® Profitest® Master and Profitest® Intro models (all trademarks mentioned here are trademarks registered by Metrawatt International GmbH at least in Europe.

Each individualising identifier 10 can be read by means of a detector that is included in a measuring device 40 or by means of a detector 41 that is connected to a measuring device 40 - for example by means of a cable 42 or wirelessly.

The identifier 10 can comprise a remote-readable code - most advantageously a bar code or a 2D bar code or an RFID chip identifier - and the detector 41 can comprise an optical scanner, most advantageously a hand-held scanner or an RFID reading device, for the reading of the remote-readable code. The scanner/reading device and/or measuring device 40 is most advantageously configured to interpret the remote-readable code.

The measuring device 40 most advantageously comprises a data structure that comprises identifiers 10, which individualise the measurement points in the electrical network of a building or property unambiguously, and that is saved in the measuring device 40, into which data structure each measurement result is saved so that the measurement result is combined with the identifier 10, which individualises the measurement point unambiguously. In addition to this or as an alternative to this, the measuring device can comprise data communications devices for sending each measurement result via a data communications connection to a processing device together with the identifier 10, which individualises the measurement point in the electrical network of a building or property unambiguously in each case.

In the method for the maintenance of the electrical network of a building or property, the method according to the invention is used for collecting measurement results from the measurement points in the electrical network of a building or property together with an identifier 10, which individualises each measurement point unambiguously in each case. In addition to this, the measurement results of each measurement point are analysed as a time series, in other words by comparing to earlier measurement results, in order to detect and/or report faults caused by the design, building or wear of the electrical network of the property.

The method is most advantageously used for predicting the wear of the electrical network of a building or property and for detecting or predicting the leakage of potential protective earthing.

In other words, the measurement results obtained from the measuring device 40 are combinable to the used identifiers 10 of the measurement points. The measurement results obtained in this way can be compared to earlier measurements, in which case faults caused by the design, building or wear of the electrical network of the property can be detected and corrected easily. This also enables the predictability of the wear of the electrical network of a building or property and the detection of the leakage of potential protective earthing before any actual significant leakage has occurred.

At present, for example all socket outlets in a socket outlet group are marked with the same identifier, for example "JK-12/4". If there are six socket outlets in the same socket outlet group, we cannot know from which socket outlet the measurement results have come from. In this way, the measurement results are not reliable, and their measurement results cannot be compared to earlier results. This also applies to earthing points and lighting points.

We mark the above-mentioned socket outlets so that the first socket outlet is JK-12/4.1 and second one is JK-12/4.2 etc.

In this way, all the identifiers used are different, in which case all information is saved precisely, and the information can be compared to each other in an annual inspection. The identifier is also printed as a 2D bar code onto the same label so that a 2D bar code reading device (detector 41) connected to the measuring device can be used for finding said measurement point, which is being measured, in the database.

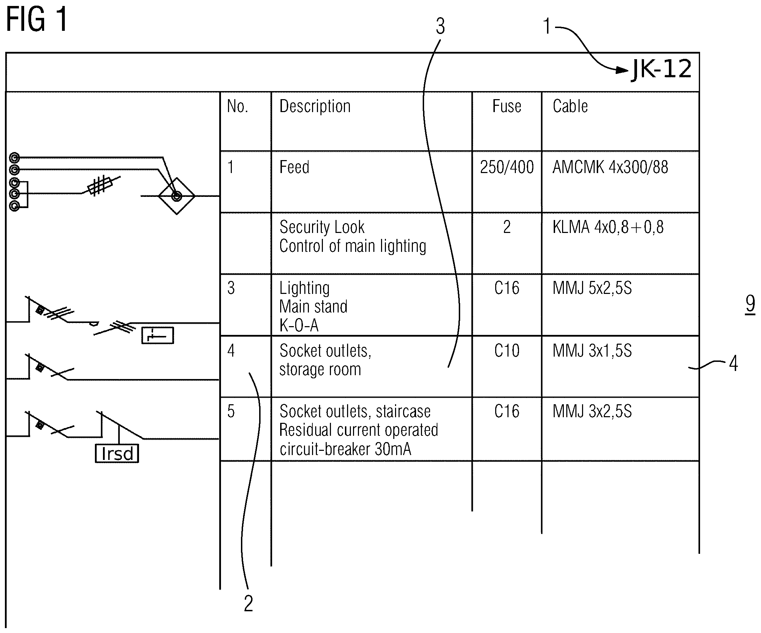

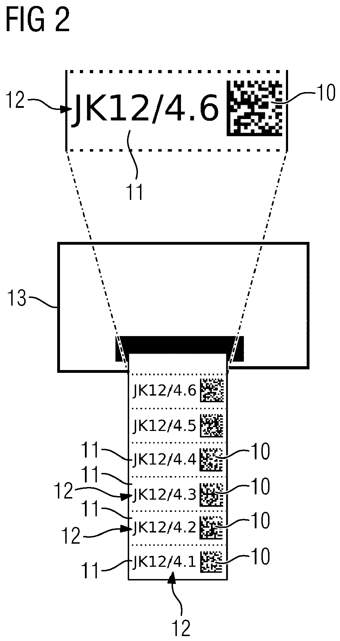

In FIG 1, in the switchboard diagram 9 of the distribution switchboard "JK-12", we identify the socket outlet group on the basis of the description (text 3) in group number 2 (group "4") A specific individualising identifier 10 is established in the method for each socket outlet 31 (for example socket outlets 1 - 6) in the socket outlet group. FIG 2 presents how after this an individualising measurement point description 11 of its own is printed for each socket outlet 31, and running numbering is printed to the descriptions 11 in connection with the text 3. The same is also printed as the identifier 10.

After this, we print, for example by means of a label printer 13, six individualising marking devices 12 (for example labels) from it, onto each of which marking devices 12 the measurement point identifier, which comprises the running numbering, and the identifier 10 are printed, which identifier 10 is most advantageously printed as a 2D bar code. After this, each marking device 12 is fastened for example by gluing to the respective correct socket outlet, lighting fixture or earthing point. In this way, all socket outlets 31 in the electrical network of a building or property can be equipped with individualising identifiers.

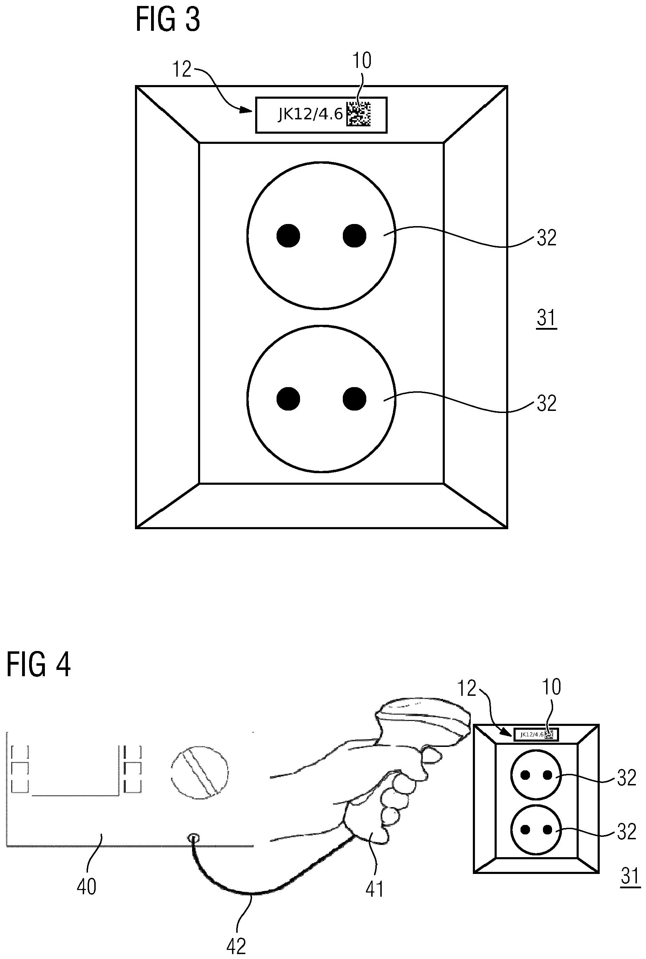

After this (FIG 4), the 2D bar code reader (detector 41) of the measuring device 40 identifies said point to be measured in its database and combines to it the measurement results obtained by means of the measuring device.

The device or system for the marking of the measurement points - most advantageously at least of the socket outlets, earthing points and lighting points - in the electrical network of a building or property comprises:
- devices for the automatic establishment of an identifier 10, which contains information on each measurement point, on the basis of the electrical network information included in the switchboard - most advantageously on the basis of the switchboard diagram 9 and/or cable installation list; and
- devices for sending each identifier to a marking device 12 for printing, for example by means of a label printer 13.

The device 40 for the collection of measurement information from the measurement points 31 in the electrical network of a building or property comprises:
devices 41 for the automatic reading of the identifiers 10, which individualise the measurement points 31 in the electrical network of a building or property unambiguously;
and
   a) a data structure saved in the device 40, into which data structure each measurement result made with the device 40 is saved so that the measurement result is combined with the identifier 10, which individualises the measurement point 31 unambiguously;
      and/or
   b) data communications devices for sending each measurement result from the device 40 via a data communications connection to a processing device together with an identifier 10, which individualises a measurement point 31 in the electrical network of a building or property unambiguously in each case.

The invention should not be understood to be limited only by the below claims, but the invention is to be understood to include all their legal equivalents and the combinations of the embodiments presented.

### List of reference numbers used:

- 1: switchboard identifier
- 2: group number
- 3: text
- 9: switchboard diagram
- 10: identifier
- 11: measurement point description
- 12: marking device
- 13: label printer
- 31: measurement point (for example socket outlet)
- 32: female connector
- 40: measuring device
- 41: detector
- 42: cable

## Claims

1. A method for the marking of the measurement points (31) - most advantageously at least of the socket outlets, earthing points and lighting points - in the electrical network of a building or property, **in which method:**
- an identifier (10), which contains information on each measurement point (31), is established automatically on the basis of the electrical network information included in a switchboard;
- the identifier (10) of each measurement point (31) is printed onto a marking device (12); and
- the marking device (12) is fastened to the measurement point (31) or to its immediate vicinity.

2. A method according to claim 1, **wherein:** the electrical network information used is a switchboard diagram (9) and/or a cable installation list.

3. A method according to claim 1 or 2, **wherein:** the identifier (10) comprises a remote-readable code or is a remote-readable code.

4. A method according to claim 3, **wherein:** the code is an optically readable code, most advantageously a bar code, a 2D bar code or an RFID chip identifier.

5. A method according to any one of the claims 1 - 4, **wherein:** the marking device (12) is a label or comprises a label.

6. A method according to any one of the claims 1 - 5, **wherein:** the identifier (10) individualises each measurement point in the electrical network of a building or property unambiguously.

7. A method for the collection of measurement information from the measurement points (31) in the electrical network of a building or property, **in which method:**
a data structure that comprises identifiers (10), which contain information on each measurement point (31) and which individualise each measurement point in the electrical network of a building or property unambiguously, is established automatically on the basis of the electrical network information included in a switchboard;
commissioning inspections and/or periodic measurements are carried out at the measurement points marked using the identifiers, which individualise each measurement point in the electrical network of the building or property unambiguously - most advantageously using the method according to claim 6 - and the measurement results are combined with the identifier (10), which individualises the measurement point (31) in the data structure unambiguously.

8. A method according to claim 7, **wherein:** each individualising identifier (10) is read by means of a detector (41) that is included in a measuring device (40) or by means of a detector (41) that is connected to a measuring device (40).

9. A method according to claim 8, **wherein:** the identifier (10) comprises a remote-readable code - most advantageously a bar code, a 2D bar code or an RFID chip identifier - and the detector (41) comprises an optical scanner, most advantageously a hand-held scanner or an RFID reading device, for the reading of the remote-readable code, and wherein the scanner/reading device and/or measuring device (40) is most advantageously configured to interpret the remote-readable code.

10. A method according to any one of the claims 7 - 9, **wherein:** the measuring device (40) comprises:
i) a data structure that comprises identifiers (10), which individualise the measurement points (31) in the electrical network of a building or property unambiguously, and that is saved in a measuring device (40), into which data structure each measurement result is saved so that the measurement result is combined with the identifier (10), which individualises the measurement point (31) unambiguously;
and/or
ii) data communications devices for sending each measurement result via a data communications connection to a processing device together with the identifier (10), which individualises the measurement point (31) in the electrical network of a building or property unambiguously in each case.

11. A method for the maintenance of the electrical network of a building or property, **in which method:**
- the method according to claim 10 is used for collecting measurement results from the measurement points (31) in the electrical network of a building or property together with an identifier (10), which individualises each measurement point unambiguously in each case; and
- the measurement results of each measurement point (31) are analysed as a time series, in other words by comparing to earlier measurement results, in order to detect and/or report faults caused by the design, building or wear of the electrical network of the property.

12. A method according to claim 11, **which is used:** for predicting the wear of the electrical network of a building or property and for detecting or predicting the leakage of potential protective earthing.

13. A device or system for the marking of the measurement points (31) - most advantageously at least of the socket outlets, earthing points and lighting points - in the electrical network of a building or property, **which device or system comprises:**
- devices for the automatic establishment of an identifier (10), which contains information on each measurement point (31), on the basis of the electrical network information included in the switchboard - most advantageously on the basis of the switchboard diagram (9) and/or cable installation list; and
- devices for sending each identifier to a marking device (12) for printing, for example by means of a label printer (13).

14. A device (40) for the collection of measurement information from the measurement points (31) in the electrical network of a building or property, **which device (40) comprises:**
devices (41) for the reading of the identifiers (10), which individualise the measurement points (31) in the electrical network of a building or property unambiguously;
and
a) a data structure saved in the device (40), into which data structure each measurement result made with the device (40) is saved so that the measurement result is combined with the identifier (10), which individualises the measurement point (31) unambiguously;
and/or
b) data communications devices for sending each measurement result from the device (40) via a data communications connection to a processing device together with the identifier (10), which individualises the measurement point (31) in the electrical network of a building or property unambiguously in each case.
